# EUROPÄISCHE PATENTSCHRIFT

(11) **EP 2 974 021 B1**
(45) Veröffentlichungstag und Bekanntmachung des Hinweises auf die Patenterteilung: **02.11.2016**
(21) Anmeldenummer: 13708832.4
(22) Anmeldetag: 12.03.2013
(51) Int. Cl.: H03K 17/16, H02J 1/00, H03K 17/0814, H03K 17/687, H02M 1/34

(54) **HOCHLEISTUNGS-DC-SCHALTER**
HIGH-POWER DC SWITCH
INTERRUPTEUR HAUTE PUISSANCE À COURANT CONTINU

(43) Veröffentlichungstag der Anmeldung: 20.01.2016
(73) Patentinhaber: Woodward IDS Switzerland AG, 8008 Zürich (CH)
(72) Erfinder: VINZENS, Martin, CH-8047 Zürich (CH)
(74) Vertreter: Cohausz & Florack
(86) Internationale Anmeldenummer: PCT/EP2013/055041
(87) Internationale Veröffentlichungsnummer: WO 2014/139559

(56) Entgegenhaltungen:
- DE-A1- 10 008 265

## Beschreibung

Die Erfindung betrifft einen Hochleistungsschalter zur Unterbrechung von DC-Stromkreisen mit zwei Strompfaden für hohe Leistungen von midestens 30kW, wobei mindestens zwei in einem der Strompfade antiseriell geschaltete Transistoren derart vorgesehen sind, dass jeder Transistor genau eine der beiden möglichen Stromrichtungen sperren oder durchschalten kann und mindestens eine Steuereinheit zur Ansteuerung der Transistoren vorgesehen ist.

Gleichstromnetze zur Übertragung hoher Leistungen gewinnen zunehmend an Bedeutung. So können beispielsweise über Hochspannungs-Gleichstrom-Übertragung (HGÜ) höchste Leistungen bei Spannungen bis zu 1000 kV wirtschaftlich übertragen werden. Diese Technologie kommt unter anderem bei Offshore Windparks zum Einsatz. Mittelgleichspannungsnetze mit Spannungen von einigen kV werden zur Verteilung von hohen Leistungen genutzt. Oftmals kommen hier Wechselrichter zum Einsatz, welche die Gleichspannung in Wechselspannung oder auch in eine andere Gleichspannung transformieren, um die notwendige lokale Leistung, beispielsweise für Elektromotoren, bereitzustellen. So werden Mittelgleichspannungsnetzwerke beispielsweise bei Schiffs- oder Bohrinselantrieben genutzt, um entsprechende Energien an die Elektromotoren der Antriebe zu übertragen. Das Trennen von Mittelgleichspannungsnetzen oder von mit hohen Gleichströmen beaufschlagten Strompfaden mit mechanischen Schaltern ist relativ langsam und die durch das Trennen hervorgerufenen Lichtbögen müssen durch hohen konstruktiven Aufwand gelöscht werden. Des Weiteren benötigen mechanische Schalter viel Bauraum und sind teuer. Halbleiterschalter, welche im Wesentlichen die Schaltfunktion durch einen Transistor bereitstellen, verursachen keine Lichtbögen und stellen zudem hohe Schaltgeschwindigkeiten zur Verfügung. Sie benötigen im Vergleich zu mechanischen Schaltern weniger Platz und sind kostengünstiger. So ist beispielsweise aus dem Aufsatz "Solid-State Circuit Breakers for Medium Voltage DC Power", M. Kempkes et al., ISBN 978-1-4244-9273-2/11, IEEE bekannt, einen Hochleistungsschalter zur Unterbrechung eines Strompfades für Mittelgleichspannungsnetze zur Verfügung zu stellen, welcher aus antiseriell angeordneten IGBT's aufgebaut ist. Aus der US-Patentanmeldung US 2011/0025400 A1 ist darüber hinaus bekannt, einen elektronischen Schalter zur Unterbrechung von DC-Strompfaden bereitzustellen, welcher unter Verwendung eines IGBT's Gleichströme mit hoher Leistung unterbrechen kann. Problematisch bei den bisher bekannten Lösungen zur Unterbrechung von Gleichstrompfaden mit hoher Leistung ist, dass weiterhin hohe Energien im Stromkreis verbleiben, welche zu Problemen bei der Unterbrechung führen können.

Aus der DE 100 08 265 A1 ist ein Standby Schalter mit zwei anti-seriell in Reihe geschalteten Feldeffekttransistoren bekannt, dessen Mittelabgriff mittels eines Widerstands und eines Schalters einem Mikrocontroller zugeführt wird.

Hiervon ausgehend liegt der vorliegenden Erfindung die Aufgabe zugrunde, einen Hochleistungsschalter zur Unterbrechung von DC-Stromkreisen zur Verfügung zu stellen, welcher einerseits eine Unterbrechung des Stromkreises bei Stromfluss in beiden möglichen Stromrichtungen ermöglicht und darüber hinaus die verbleibende Restenergie aus den Stromkreisen kontrolliert abführt.

Die aufgezeigte Aufgabe wird nach der Lehre der vorliegenden Erfindung dadurch gelöst, dass zwischen den antiseriellen Transistoren des Strompfades ein zuschaltbarer ohmscher Widerstand vorgesehen ist, über welchen der Stromkreis kurzgeschlossen werden kann.

Es hat sich gezeigt, dass durch die Anordnung eines zuschaltbaren ohmschen Widerstandes zwischen den antiseriell in einem Strompfad angeordneten Transistoren des Hochleistungsschalters eine einfache Möglichkeit besteht, bei Unterbrechung des Strompfades durch einen der antiseriellen Transistoren die im Strompfad verbleibende Energie über den ohmschen Widerstand schnell abzubauen, sodass der abgetrennte Strompfad vollständig stromlos ist. Darüber hinaus werden über den zuschaltbaren ohmschen Widerstand beim Trennen entstehende, induzierte Spannungs- und/oder Stromspitzen, welche aufgrund der hohen Spannungen und Ströme auch bei geringen Induktivitäten entstehen können, gedämpft. Unter dem Begriff "hohe Leistungen" bzw. unter dem Begriff "Hochleistungsschalter zur Unterbrechung von DC-Stromkreisen", werden erfindungsgemäß Schalter verstanden, die für Ströme ab 50A bei Spannungen ab 600Vdc, d.h. also die für eine Mindestleistung von 30kW ausgelegt sind. Hier hat sich die Anordnung eines zuschaltbaren ohmschen Widerstands als einfache Möglichkeit ergeben, einen kompakten Leistungsschalter bereitzustellen, welcher neben dem Trennen auch bei hohen Leistungen zusätzlich eine große Betriebssicherheit besitzt. Durch das Verwenden einer Steuereinheit zum Trennen und Kurzschließen der Strompfade über den ohmschen Widerstand kann zudem ein nahezu autarker und wartungsarmer Hochleistungsschalter bereitgestellt werden, welcher lediglich über Ein- bzw. Ausgänge mit dem Stromkreis verbunden werden muss, um ein sicheres Abtrennen des Strompfades zu ermöglichen.

Gemäß einer ersten Ausgestaltung des Hochleistungsschalters sind IGBT's mit Freilaufdioden zur Bereitstellung der antiseriellen Transistoren im Strompfad vorgesehen. Üblicherweise sind IGBT's und Freilaufdioden direkt in einem Gehäuse baulich vereint. Es sind auch andere Halbleiterschalter wie z.B. FET's oder IGCT's denkbar. Zur Übertragung von Gleichstrom werden grundsätzlich zwei Strompfade benötigt, zwischen denen die Gleichspannung anliegt. Üblicherweise werden die beiden Strompfade als positiver Pfad mit positivem Potential bzw. als negativer Pfad mit negativem oder null Potential bezeichnet. Bevorzugt kommt der erfindungsgemäße Hochleistungsschalter im positiven Pfad zum Einsatz, denkbar ist aber auch eine Verwendung im negativen Pfad. Die IGBT's können hohe Leistungen in extrem kurzen Zeiten schalten und ermöglichen beispielsweise im Vergleich zu mechanischen Schaltern sowohl ein Einschalten als auch ein Ausschalten, ohne dass Lichtbögen entstehen. Die Freilaufdioden schützen den IGBT vor Spannungsspitzen, welche aus den Schaltvorgängen resultieren können.

Ist gemäß einer weiteren Ausführungsform des Hochleistungsschalters mindestens ein Transistor zum Schalten des ohmschen Widerstandes vorgesehen, kann der ohmsche Widerstand elektronisch auf einfache Weise zugeschaltet werden. Dieser Transistor wird auch als Chopper bezeichnet. Prinzipiell ist es auch möglich, mehrere parallel geschaltete Transistoren zum Zuschalten des ohmschen Widerstandes zu verwenden, sofern die abzuführende Leistung für die Verwendung eines einzelnen Transistors zu groß ist.

Gemäß einer weiteren Ausführungsform des Hochleistungsschalters ist der mindestens eine Transistor zum Schalten des ohmschen Widerstandes über eine Steuereinheit, welche auch die in einem Strompfad angeordneten antiseriell geschalteten Transistoren ansteuert, oder alternativ über einen Choppertreiber zuschaltbar. Im normalen Betrieb übernimmt die Steuereinheit die Ansteuerung des Choppers. Steigt beispielsweise durch eine Fehlfunktion der Steuereinheit die Spannung zwischen den beiden antiseriell geschalteten Transistoren über eine vorgegebene Schwelle an, so kann dies beispielsweise über eine Spannungsmessung vom Choppertreiber detektiert werden, so dass dieser dann den Chopper zuschalten kann.

Um den Hochleistungsschalter in Bezug auf die schaltbaren Leistungen zu skalieren, kann gemäß einer weitergebildeten Ausführungsform mindestens ein Strompfad mehrere parallele Unterstrompfade aufweisen, in welchen jeweils zwei antiseriell geschaltete Transistoren derart vorgesehen sind, dass jeder Transistor jeweils eine Stromrichtung des Unterstrompfades sperren oder durchschalten kann. Der Leistungsbereich des Hochleistungsschalters kann durch diese Maßnahme erheblich erweitert werden, da durch die parallelen Unterstrompfade lediglich Teilströme über die jeweiligen Unterstrompfade geführt werden, sodass beispielsweise bei gleicher Auslegung und Aufteilung des Strompfades in zwei Unterstrompfade doppelt so große Gleichströme geschaltet werden können. Der Leistungsbereich kann damit beispielsweise ebenfalls verdoppelt werden.

Gemäß einer weiteren Ausgestaltung kann jeder der Unterstrompfade zwischen den antiseriellen Transistoren über mindestens einen geschalteten ohmschen Widerstand kurzgeschlossen werden. Beispielsweise kann für jeden Unterstrompfad ein eigener, geschalteter ohmscher Widerstand vorgesehen sein, um sehr große Leistungen in den Unterstrompfaden kurzschließen zu können. Vorzugsweise wird jedoch lediglich ein einziger geschalteter ohmscher Widerstand vorgesehen, über welchen die Unterstrompfade kurzgeschlossen werden können, um einen möglichst einfachen Hochleistungsschalter bereitzustellen.

Ist jeder Unterstrompfad über eine Diode mit dem mindestens einen geschalteten Widerstand verbunden, kann verhindert werden, dass bei der Verbindung mehrerer Unterstrompfade mit dem gleichen geschalteten, ohmschen Widerstand Kreisströme über die Unterstrompfade entstehen können.

Der Hochleistungsschalter kann darüber hinaus dadurch weiter ausgestaltet werden, dass eine parallel zum zuschaltbaren ohmschen Widerstand und zum zugehörigen Transistor geschaltete Kapazität vorgesehen ist und optional eine Freilaufdiode parallel zum ohmschen Widerstand vorgesehen ist. Die parallel zum Transistor und zugehörigen ohmschen Widerstand geschaltete Kapazität dient als Energiespeicher, um die am Verknüpfungspunkt der beiden Dioden und des ohmschen Widerstandes anliegende Spannung zu "glätten" und somit ein unerwünschtes zu schnelles Ein- und Abschalten des Transistors zu vermeiden. Die Freilaufdiode baut mögliche Überspannungen ab, die beim Abschalten des Choppertransistors durch parasitäre Induktivitäten hervorgerufen werden.

Gemäß einer weiteren Ausgestaltung des Hochleistungsschalters sind am Eingang, am Ausgang des Schalters und/oder zwischen den mindestens zwei antiseriell geschalteten Transistoren Mittel zur Spannungs- und/oder Strommessung vorgesehen. Als Eingang und Ausgang des Hochleistungsschalters werden die Bereiche des Hochleistungsschalters bezeichnet, welche nicht zwischen zwei antiseriell angeordnete Transistoren angeordnet sind. Durch die vorgesehenen Mittel zur Spannungs- und/oder Strommessung können über oder unter vorgegebenen Schwellen liegende Spannungs- und/oder Stromwerte ermittelt und zum Auslösen eines Schaltereignisses verwendet werden. Mit einem Schaltereignis ist das Sperren oder das Durchschalten der antiseriell geschalteten Transistoren bzw. des Choppers gemeint. Vorzugsweise sind die Mittel zur Spannungs- und/oder Strommessung mit der Steuereinheit verbunden, sodass die Steuereinheit entsprechende Schaltbefehle anhand der Messungen, beispielsweise bei Über- oder Unterschreiten von vorgegebenen Werten, generieren kann. Die Strommessung erfolgt dabei vorzugsweise am Eingang des Schalters, sodass die eingehenden Ströme erfasst werden können, um den Schalter im Überspannungs- oder Überstromfall zu schalten.

Aufgrund der hohen Leistungen, für welche der Hochleistungsschalter ausgelegt ist, ist es vorteilhaft in Stromrichtung vor und/oder hinter den antiseriell geschalteten Transistoren die Strompfade über ein Dämpfungsglied zu verbinden und optional eine zum Dämpfungsglied parallel geschaltete Diode vorzusehen. Durch die entsprechende Anordnung eines Dämpfungsgliedes dU/dT in Verbindung mit der entsprechenden parallel geschalteten Diode kann eine zusätzliche Bedämpfung zur Vermeidung von durch das Abschalten der Transistoren hervorgerufenen induzierten Spannungsspitzen erreicht werden. Die Dämpfungsglieder werden üblicherweise als sogenannte "Snubber Circuits" bezeichnet.

Ist gemäß einer weiteren Ausführungsform des Hochleistungsschalters mindestens ein Temperatursensor vorgesehen, dessen Messsignal an die Steuereinheit übertragen wird, kann die Temperatur des Hochleistungsschalters überwacht werden und so die Lebensdauer des Hochleistungsschalters verlängert werden. Temperatursensoren können beispielsweise auf dem Kühlkörper der Transistoren montiert werden, aber auch jeweils in den einzelnen IGBT's oder anderen Bauelementen des Hochleistungsschalters vorgesehen sein.

Üblicherweise sind die IGBT's gekühlt, vorzugsweise wassergekühlt, um die aufgrund der hohen Leistungen auftretende Wärme abzuführen. Eine Luftkühlung kann aber unter bestimmten Umständen auch vorteilhaft sein.

Gemäß einer weiteren Ausgestaltung des Hochleistungsschalters kann die Steuereinheit einen der Strompfade oder alle parallelen Unterstrompfade trennen und die Strom- oder Unterstrompfade über den mindestens einen geschalteten ohmschen Widerstand bei einem oder mehrerer der folgenden Zustände kurzschließen:
- Überschreiten eines vorbestimmten Gesamtstromwertes im Strompfad oder Teilstromwertes im Unterstrompfad,
- Überschreiten eines vorgegebenen Spannungswertes am Eingang, Ausgang oder am DC-Chopper bzw. ohmschen Widerstand,
- Überschreiten einer vorgegebenen Spannungsdifferenz zwischen Eingang und Ausgang,
- Überschreiten eines Temperaturwertes oder
- Anliegen eines übergeordneten Schaltsignals.

Über die Überschreitung eines vorbestimmten Gesamtstromwertes im Strompfad oder Teilstromwertes im Unterstrompfad kann eine Überlast festgestellt werden und der Strompfad unterbrochen werden. Dies entspricht der Funktion einer Schmelzsicherung. Die Überschreitung eines vorgegebenen Spannungswertes am Eingang, Ausgang oder am DC-Chopper oder die Überschreitung einer vorgegebenen Spannungsdifferenz zwischen Eingang und Ausgang ermöglicht die Detektion von Überspannungszuständen, welche ebenfalls im Gleichstromnetz zu Schäden an angeschlossenen Verbrauchern führen können. Diese Schäden können ebenfalls durch den Hochleistungsschalter vermieden oder zumindest reduziert werden. Durch ein Überschreiten eines Temperaturwertes, beispielsweise in einem IGBT oder im gesamten Hochleistungsschalter, kann eine Überlastung des Hochleistungsschalters ermittelt werden. Darüber hinaus besteht die Möglichkeit durch ein übergeordnetes Schaltsignal eine Trennung des Strompfades zu bewirken. Somit kann der erfindungsgemäße Hochleistungsschalter als ein fernbedienbares Schaltelement eingesetzt werden.

Gemäß einer weiteren Ausführungsform des Hochleistungsschalters kann die Steuereinheit einen der Strompfade oder alle parallelen Unterstrompfade bei einem oder mehrerer der folgenden Zustände durchschalten:
- Unterschreiten eines vorbestimmten Gesamtstromwertes im Strompfad oder Teilstromwertes im Unterstrompfad,
- Unterschreiten einer vorgegebenen Spannung am Eingang, Ausgang oder am DC-Chopper,
- Unterschreiten einer vorgegebenen Spannungsdifferenz zwischen Eingang und Ausgang
- Unterschreiten eines Temperaturwertes,
- Anliegen eines übergeordneten Schaltsignals.

Das Durchschalten bzw. Wiederzuschalten der Strompfade nach einer Abschaltung kann dann ermöglicht werden, wenn vorbestimmte Grenzwerte nicht mehr überschritten sind. Ist beispielsweise der Strom im Gesamtstrompfad oder in den Unterstrompfaden bzw. die Spannung am Eingang, Ausgang oder am DC-Chopper noch nicht auf ein zulässiges Maß abgeklungen, so sind die Überstrom- oder Überspannungszustände noch vorhanden, ein Wiederzuschalten kann somit verhindert werden. Weisen die beiden am Eingang und Ausgang des Schalters gemessenen Spannungen beispielsweise eine unter einem vorgegebenen Wert liegende Differenz, beispielsweise 5V - 10V auf, kann ein Wiederzuschalten erfolgen. Ist die Differenz der beiden Spannungen noch zu hoch, würde durch das Zuschalten ein hoher Strom hervorgerufen, welcher zum erneuten Abschalten führen könnte. Durch ein Unterschreiten eines Temperaturwertes, beispielsweise eines IGBT's, kann eine Abkühlung auf ein für einen ordnungsgemäßen Betrieb erforderliches Maß erreicht werden. Auf diese Weise kann z. B. eine mehrfach verwendbare und sich selbsttätig wiederzuschaltende Sicherung realisiert werden. Durch ein übergeordnetes Schaltsignal kann das Zuschalten des Hochleistungsschalters bewirkt werden, um somit die Funktion als fernbedienbares Schaltelement zu ermöglichen.

Vorzugsweise sind zum Ansteuern der IGBT's Treibereinheiten vorgesehen. Treibereinheiten sind Komponenten oder Schaltungen, die z.B. elektrische oder optische Ansteuersignale von Steuer- und Kontrolleinheiten umwandeln, in Steuerspannungen aufbereiten und dann an die Ansteueranschlüsse der z.B. IGBTs oder Thyristoren weiterleiten. Die Signalaufbereitung erfolgt derart, dass sie innerhalb der spezifizierten Parameter der Schalter (IGBT, Thyristor) liegen und einen sicheren Betrieb gewährleisten. Die Treibereinheiten können auch Schutzfunktionen wie Überstromschutz (Vce sat Detektion), Überspannungsschutz (Active Clamping), Überwachung der Speisespannung und der Komponententemperatur (des Treibers oder des IGBTs, Thyristors) beinhalten. Üblicherweise werden die Treibereinheiten in unmittelbarer räumlicher Nähe zu den IGBT's angeordnet

Da der erfindungsgemäße Hochleistungsschalter in Gleichstromkreisen einen Strompfad in beiden Stromrichtungen schalten und gleichzeitig ein schnelles stromlos Schalten des abgetrennten Strompfades sicherstellen kann, wird der Schalter vorzugsweise in verteilten DC-Stromnetzen, in Hochspannungsgleichstromnetzen, in DC-Versorgungsnetzen von mit Wechselrichtern betriebenen elektrischen Antrieben , Generatoren oder Energiespeichern verwendet. Nicht nur die kompakte Bauweise, der einfache Aufbau sondern insbesondere auch die extrem kurzen Schaltzeiten bei gleichzeitig sicherem stromlos Schalten des abgetrennten Strompfades führt der Hochleistungsschalter in DC-Stromnetzen zu einer deutlichen Vereinfachung des Aufbaus von DC-Stromnetzen.

So können beispielsweise unterschiedliche Quellen eines DC-Stromnetzes über einen erfindungsgemäßen Hochleistungsschalter kombiniert ein DC-Stromnetz mit elektrischer Energie versorgen.

Gemäß einer weiteren Ausführungsform wird der Hochleistungsschalter in Antrieben für Schiffe, Bohrinseln, Seilwinden, Pumpenantriebe und Kraftfahrzeugen verwendet, da hier oft verteilte DC-Stromnetze zur Stromversorgung von entfernten Antrieben verwendet werden. Bei Kraftfahrzeugen ist dies beispielsweise bei spezifischen Grubenfahrzeugen der Fall. Schiffsantriebe, Antriebe für Bohrinseln oder Seilwinden aber auch Pumpenantriebe benötigen sehr große Energiemengen, welche über ein Gleichstromnetz bereitgestellt werden. Die Antriebe selber verwenden wiederum Wechselstrom, welcher über einen Wechselrichter erzeugt wird. Die Bereitstellung der Energie am Wechselrichter kann über den Hochleistungsschalter in der Form sichergestellt werden, dass unterschiedliche Stromquellen bzw. Generatoren ein einziges Gleichstromnetz mit Energie versorgen können und beispielsweise bei Ausfall eines Generators ein weiterer ohne weiteres zugeschaltet werden kann und fehlerhafte Bereiche abgetrennt werden um einen unterbrechungsfreien Betrieb des verbleibenden Teils zu gewährleisten.

Die Erfindung soll im Weiteren anhand von Ausführungsbeispielen in Verbindung mit der Zeichnung näher erläutert werden. In der Zeichnung zeigt:
- Fig. 1: ein Schaltbild eines ersten Ausführungsbeispiels eines Hochleistungsschalters,
- Fig. 2: ein zweites Ausführungsbeispiel eines Hochleistungsschalters mit Temperaturüberwachung,
- Fig. 3: ein schematisches Schaubild eines konventionellen Gleichstromnetzes mit zwei alternativen Generatoren,
- Fig. 4: ein Ausführungsbeispiel eines Leistungsschalters in einem verteilten DC-Stromnetz und
- Fig. 5: ein weiteres Ausführungsbeispiel zur Verwendung des Hochleistungsschalters in einem verteilten DC-Stromnetz.

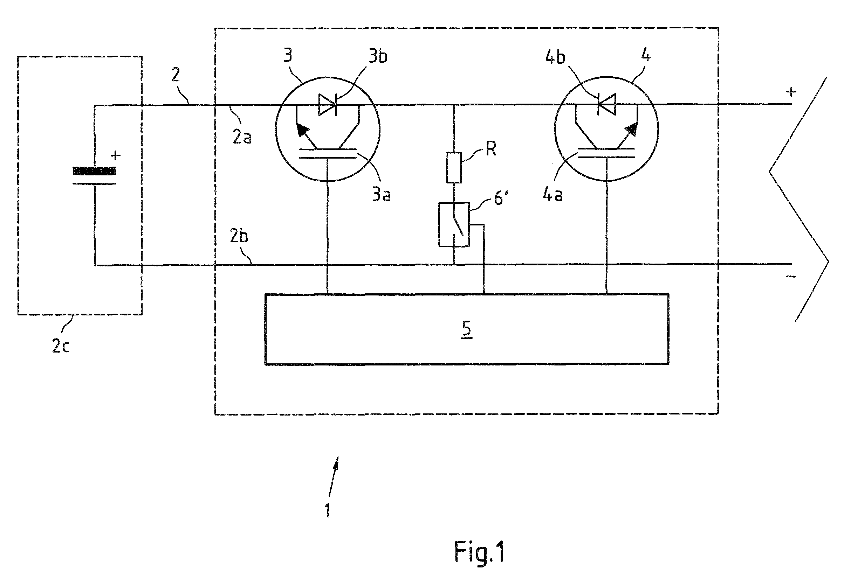

Fig. 1 zeigt in einem schematischen Schaltbild ein erstes Ausführungsbeispiel des Hochleistungsschalters 1 zur Unterbrechung von DC-Stromkreisen 2 mit zwei Strompfaden 2a, 2b einer Stromquelle 2c, welcher für hohe Leistungen ausgelegt ist. Als hohe Leistungen werden erfindungsgemäß Stromstärken von mindestens 50A, vorzugsweise mindestens 100A bei Spannungen von mindestens 600V, also ab 30 kW Leistung angesehen. Bevorzugt wird der Hochleistungsschalter zum bidirektionalen Unterbrechen von DC-Stromkreisen mit einer Stromstärke von 2000A bis 4000A bei einer Spannung von 800 bis 2000V verwendet. Entsprechende Hochleistungsschalter unterscheiden sich insbesondere von DC-Schaltern für geringe Leistungen, d.h. niedrige Spannungen und Ströme dadurch, dass diese aufgrund ihres Aufbaus, beispielsweise aufgrund der Leiterquerschnitte und Leiterformen sehr geringe Induktivitäten und Widerstände aufweisen, um große DC-Ströme führen zu können, ohne Spannungsspitzen bei einem Lastwechsel zu induzieren. Beispielsweise werden die Strompfade im Hochleistungsschalter über eine Busverschienung realisiert. Der Aufbau des Hochleistungsschalters ist daher an ein Schalten sehr hoher Leistungen angepasst.

In dem in Fig. 1 dargestellten Ausführungsbeispiel sind im Strompfad 2a zwei antiseriell geschaltete Transistoren 3, 4 angeordnet, mit welchen der Strompfad 2a bidirektional unterbrochen werden kann. Mit anderen Worten jeder der einzelnen Transistoren kann den Stromfluss in eine der beiden möglichen Stromrichtungen sperren. Zwischen beiden antiseriell geschalteten Transistoren 3, 4 ist der Strompfad 2a über einen zuschaltbaren ohmschen Widerstand R mit dem Strompfad 2b kurzschließbar. Zum Kurzschließen kann, wie im vorliegenden Ausführungsbeispiel, über die Steuereinheit 5 beispielsweise ein Schalter 6' geschlossen werden, sodass eventuell nach dem Unterbrechen des Stromkreises 2 noch im Stromkreis befindliche Energie über den ohmschen Widerstand R abgebaut und die Strompfade vollständig stromlos geschaltet werden können. Insbesondere ergibt sich durch die Anordnung des zuschaltbaren ohmschen Widerstands zwischen den antiseriellen Transistoren die Möglichkeit, die beim Unterbrechen von DC-Stromkreisen mit hohen Leistungen auftretenden Spannungs- und/oder Stromspitzen unmittelbar über den Widerstand R abbauen zu können, so dass angeschlossene Verbraucher keinen Schaden nehmen können. Der erfindungsgemäße Hochleistungsschalter zeichnet sich damit durch eine besonders gute und in Bezug auf die übrigen angeschlossenen Komponenten des DC-Stromkreises schonende Unterbrechung aus. Dadurch, dass sowohl die Steuereinheit 5 die antiseriellen Transistoren 3,4 als auch den zuschaltbaren ohmschen Widerstand R schaltet, besitzt das dargestellte Ausführungsbeispiel des erfindungsgemäßen Hochleistungsschalters einen kompakten Aufbau und kann an beliebigen Stellen im DC-Stromnetz positioniert und nahezu autark betrieben werden.

Wie bereits in Fig. 1 zu erkennen ist, werden die Transistoren 3, 4 über IGBT's 3a, 4a, welche jeweils mit einer Freilaufdiode 3b, 4b ausgestattet sind, bereitgestellt. Die Freilaufdioden 3b und 4b dienen zum Schutz der IGBT's 3a und 4a. IGBT's zeichnen sich vor allem dadurch aus, dass diese extrem hohe Ströme schalten können und zudem extrem kurze Schaltzeiten bereitstellen können. Hierdurch ist es möglich, sehr große Leistungen pro Hochleistungsschalter bidirektional zu unterbrechen. Wie im Ausführungsbeispiel in Fig. 1 dargestellt, dient ein Schalter 6', welcher über die Steuereinheit 5 angesteuert werden kann, zum Zuschalten des ohmschen Widerstandes R und damit zum Kurzschließen des Stromkreises 2.

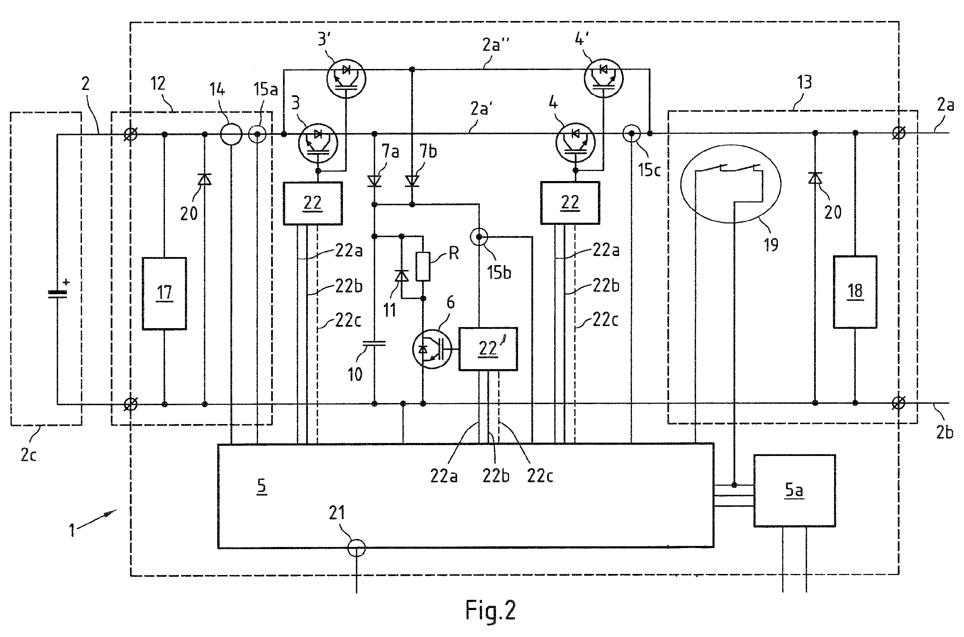

In Fig. 2 ist ein Schaltbild eines weiteren Ausführungsbeispiels eines Hochleistungsschalters 1 zur bidirektionalen Unterbrechung von DC-Stromkreisen dargestellt. In diesem Ausführungsbeispiel wird der zuschaltbare ohmsche Widerstand R über einen Transistor 6 zugeschaltet, wobei der Transistor 6 ebenfalls durch einen IGBT inklusive Freilaufdiode bereitgestellt wird. Das vorliegende Ausführungsbeispiel in Fig. 2 unterscheidet sich von dem in Fig. 1 dargestellten Ausführungsbeispiel dadurch, dass der Strompfad 2a in die beiden Unterstrompfade 2a' und 2a" aufgeteilt wird, wobei jeder Unterstrompfad 2a' und 2a" durch jeweils zwei antiseriell geschaltete Transistoren 3, 3', 4, 4' in Bezug auf die mögliche Stromrichtung unterbrochen werden kann. Die Transistoren 3, 3', 4, 4' sind bevorzugt als IGBT's mit Freilaufdiode ausgebildet, um möglichst hohe Leistungen schalten zu können und gleichzeitig extrem kurze Schaltzeiten zur Verfügung zu stellen. Beide Unterstrompfade 2a', 2a" sind über eine in Durchlassrichtung geschaltete Diode 7a, 7b mit dem mindestens einen zuschaltbaren ohmschen Widerstand R verbunden. Die Dioden 7a, 7b verhindern, dass bei Schaltvorgängen des Choppers ein Stromfluss zwischen den einzelnen Unterstrompfaden erzeugt wird. Beide Unterstrompfade 2a', 2a" lassen sich durch diese Anordnung über einen gemeinsamen zuschaltbaren ohmschen Widerstand R mit dem Strompfad 2b kurzschließen. Die Kapazität 10 dient als Energiespeicher, um die am Verknüpfungspunkt der beiden Dioden 7a und 7b des ohmschen Widerstandes R anliegende Spannung zu "glätten" und somit ein unerwünschtes zu schnelles Ein- und Abschalten des Transistors 6 zu vermeiden. Die Freilaufdiode 11 baut mögliche Überspannungen ab, die beim Abschalten des Choppertransistors 6 durch parasitäre Induktivitäten, beispielsweise des ohmschen Widerstands R, hervorgerufen werden.

Am Eingang 12 des Hochleistungsschalters 1 sowie am Ausgang 13 und zwischen den zwei antiseriell geschalteten Transistoren 3, 3', 4, 4' sind Mittel 15a, 15b, 15c zur Spannungsmessung und Mittel 14 zur Strommessung vorgesehen. Die gemessenen Werte für Strom oder Spannung werden an die Steuereinheit 5 weitergeleitet. Die Steuereinheit 5 kann eine Auswerteeinheit umfassen, welche anhand der Messsignale Schaltsignale generiert, oder die Werte an eine übergeordnete Steuerung weitergeben. Die Transistoren 3, 3', 4, 4', 6 können somit anhand von Spannungsmesswerten und/oder Strommesswerten gesteuert werden und beispielsweise im Überspannungsfall oder auch zu hoher Strombelastung zu einer Unterbrechung des Stromkreises 2 führen. Hierdurch kann beispielsweise die Spannungs- bzw. Stromquelle 2c oder auch nicht dargestellte, am Eingang 12 oder Ausgang 13 angeschlossene Verbraucher geschützt werden. Die Steuereinheit weist Eingänge auf, um die Messsignale der Messmittel 14, 15a, 15b, 15c zu empfangen. Vorzugsweise ist die Steuereinheit auch mit einer Auswerteeinheit versehen, so dass ein Betrieb ohne übergeordnete Steuerung möglich ist.

Darüber hinaus ist in Fig. 2 auch ein Temperatursensor 19 dargestellt, welcher im einfachsten Fall beispielsweise durch einen Bimetallsensor ausgebildet sein kann, welcher der Steuereinheit 5 ein Signal zur Zustandsüberwachung des Hochleistungsschalters übergeben kann. Natürlich sind auch andere Temperatursensoren, wie beispielsweise PT100-Elemente denkbar. Alternativ oder kumulativ zu dem dargestellten Temperatursensor, welcher auch an die Spannungsquelle 5a der Steuereinheit angebunden ist, kann beispielsweise in jedem der IGBT's oder in den entsprechenden Treibereinheiten ein Temperatursensor enthalten sein, welcher Temperaturwerte an die Steuereinheit 5 übergibt, welche die Temperaturmesswerte dann auswertet und entsprechende Schaltsignale generiert. Zusätzlich sind in dem vorliegenden Ausführungsbeispiel am Eingang 12 oder am Ausgang 13 des Schalters die Strompfade 2a und 2b über ein dU/dt Dämpfungsglied 17, 18 miteinander verbunden. Ein solches Dämpfungsglied wird auch als Snubber bezeichnet und besteht in der Regel aus einer Serienschaltung eines ohmschen Widerstandes und eines Kondensators, jedoch sind auch alternative Beschaltungen möglich. Mit der parallel geschalteten Diode 20 kann eine zusätzliche Bedämpfung zur Vermeidung von induzierten Spannungsspitzen im Falle des Abschaltens der Transistoren 3, 3', 4, 4' erreicht werden.

Die Steuereinheit 5 des Ausführungsbeispiels in Fig. 2 kann einen der Strompfade bzw. alle parallelen Unterstrompfade trennen bzw. zuschalten und die Strompfade bzw. Unterstrompfade über den mindestens einen zuschaltbaren ohmschen Widerstand R bei einem oder mehrerer der folgenden Zustände kurzschließen bzw. die Verbindung über den Widerstand R trennen:
- Überschreiten oder Unterschreiten eines vorbestimmten Gesamtstromwertes im Strompfad oder Teilstromwertes im Unterstrompfad anhand einer Strommessung 14,
- Überschreiten oder Unterschreiten eines vorgegebenen Spannungswertes am Eingang 15a, Ausgang 15c oder am DC-Chopper 15b durch eine Spannungsmessung,
- Überschreiten oder Unterschreiten einer vorgegebenen Spannungsdifferenz zwischen Eingang 15a und Ausgang 15c durch eine Spannungsmessung,
- ein Überschreiten oder Unterschreiten eines Temperaturwertes, beispielsweise durch Messung des Temperatursensors 19 oder der Temperatursensoren in den IGBT's oder
- Anliegen eines übergeordneten Schaltsignals zur Unterbrechung oder Verbindung der Stromkreise, welches über den Eingang Enable 21 an der Steuereinheit anliegt.

Um eine möglichst hohe Geschwindigkeit beim Unterbrechen der Stromkreise zu erreichen, werden bevorzugt IGBT's verwendet, um die Strompfade zu unterbrechen oder den zuschaltbaren ohmschen Widerstand zuzuschalten. Zur Ansteuerung werden Treibereinheiten 22 bzw. Choppertreiber 22' verwendet, welche nach Möglichkeit in unmittelbarer Nähe der IGBT's positioniert werden und welche, im Falle der Ansteuerung mehrerer IGBT's über eine einzige Treibereinheit, wie es in Fig. 2 dargestellt ist, bevorzugt symmetrische Leitungsabschnitte zu den einzelnen IGBT's aufweisen, um einen symmetrischen Schaltvorgang der Unterstrompfade 2a', 2a" zu erzielen. Prinzipiell kann auch für jeden Transistor eine eigene Treibereinheit 22 vorgesehen sein. In der Regel sind die Treibereinheiten 22 zusätzlich mit einer Spannungsversorgung über Versorgungsleitungen 22a, 22b ausgestattet. Dies gilt auch für den Choppertreiber 22'. Um die großen Stromflüsse in dem Hochleistungsschalter zu ermöglichen, sind die Strompfade und Unterstrompfade durch ausreichend dimensionierte Leiter, beispielsweise Kupferschienen bereitgestellt, welche bevorzugt symmetrisch ausgebildet sind, um ein möglichst identisches Schaltverhalten zu ermöglichen. Eine symmetrische Stromaufteilung zwischen den Schaltern 3 und 3', bzw. 4 und 4' ist wichtig, da ansonsten Überbelastungen an einzelnen Komponenten oder Strompfaden auftreten können. Eine symmetrische Aufteilung ermöglicht zudem eine kostengünstigere Dimensionierung der Schaltung da durch unsymmetrische Teilströme eine größere Dimensionierung der Komponenten notwendig wäre.

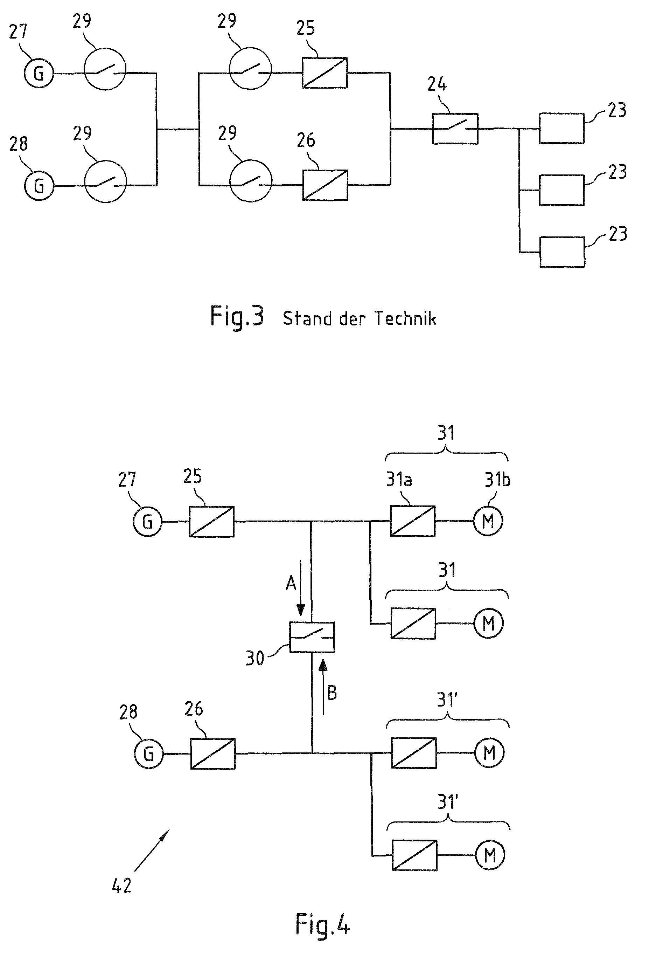

Fig. 3 zeigt nun ein konventionell aufgebautes DC-Stromnetz mit mehreren DC-Verbrauchern 23, einem unidirektionalen DC-Schalter 24 sowie zwei AC/DC-Wechselrichtern 25, 26, welche die vom Generator erzeugte Wechselspannung in Gleichspannung umwandeln und diese über den unidirektionalen Schalter 24 an die Verbraucher 23 weitergeben. Um die AC-Generatoren 27, 28 sowie die AC/DC-Wechselrichter 25. 26 lastabhängig einsetzen zu können, sind darüber hinaus vier Wechselstromschalter 29 vorgesehen, welche eine maximale Flexibilität im Hinblick auf die Versorgung der Verbraucher 23 gewährleisten. Die Generatoren 27, 28 können beispielsweise Dieselgeneratoren sein. Diese arbeiten nur bei relativ hohen Leistungen effizient. Wird nun von den Verbrauchern nur eine geringe Leistung benötigt, kann ein Generator alleine die geforderte Leistung bereitstellen, anstatt beide Generatoren im Teillastbereich arbeiten zu lassen. Der andere Generator wird über den zugehörigen Wechselstromschalter 29 vom AC-Netz getrennt. Ebenso können die AC/DC-Wechselrichter 25, 26 über die zugehörigen AC-Schalter 29 Lastabhängig vom AC-Netz getrennt werden.

Unter Verwendung des erfindungsgemäßen Hochleistungsschalters ist es möglich, das gesamte DC-Stromnetz wesentlich einfacher zu gestalten und eine ähnliche Flexibilität im Hinblick auf den Einsatz der Generatoren 27, 28 zu gewährleisten. Dies zeigt Fig. 4. Das schematische Schaltbild in Fig. 4 zeigt zwei AC-Generatoren 27, 28, welche über zwei AC/DC-Wechselrichter 25, 26 an das Gleichstromnetz angebunden sind. Der erfindungsgemäße Hochleistungsschalter 30 kann sowohl in Stromflussrichtung A oder in Stromflussrichtung B den Generator 28 bzw. den Generator 27 mit den Verbrauchern 31, 31' verbinden. Die Verbraucher sind hier durch einen DC/AC-Wechselrichter 31a, welcher den zur Verfügung gestellten Gleichstrom bzw. die Gleichspannung in eine Wechselspannung zum Antreiben des Motors 31b umwandelt. Identische Verbraucher sind mit 31' dargestellt.

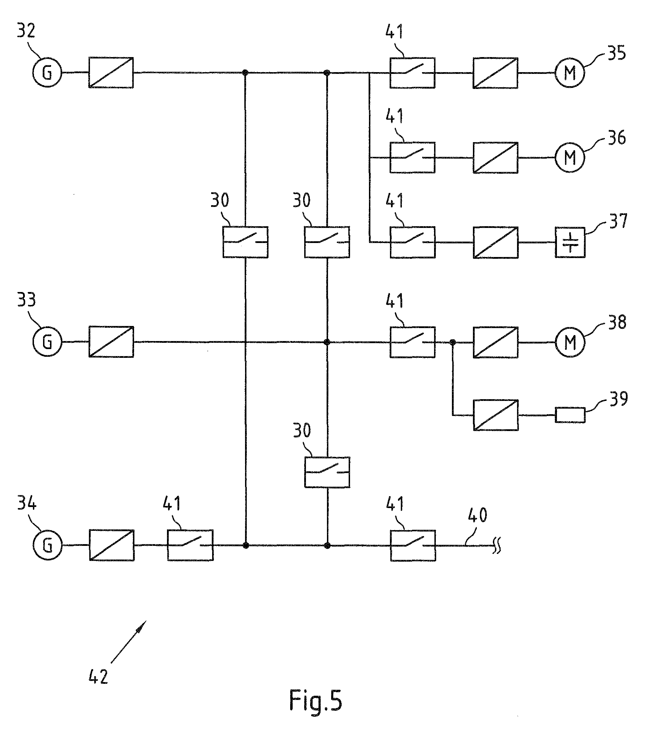

Einen deutlich komplexeren Aufbau eines DC-Stromnetzwerkes 42 zeigt Fig. 5, bei welcher über die erfindungsgemäßen Hochleistungsschalter 30 Teilnetzbereiche flexibel miteinander verbunden werden können. Die erfindungsgemäßen Hochleistungsschalter 41 dienen hingegen zum gezielten Abschalten einzelner Erzeuger 34 oder Verbraucher 35, 36, 37, 40, bzw. Verbrauchergruppen 38 und 39. Als Verbraucher sind in Fig. 5 wiederum Kombinationen aus Wechselrichter und Motor 35, 36, Wechselrichter und DC-Speichereinheit 37 sowie Wechselrichter und DC-Verbraucher 39 dargestellt. Durch die Ermöglichung des Stromflusses in beide Richtungen über die Schalter 30, 41 ist es möglich, dass beispielsweise der DC-Energiespeicher 37 sowohl Energie aus dem DC-Netz bezieht, als auch wieder in das DC-Netz abgibt. Auch die Motoren 35, 36, 38 können im Bremsbetrieb arbeiten und dabei Energie in das DC-Netz zurückspeisen.

Gerade in dem in Fig. 5 dargestellten Ausführungsbeispiels eines verteilten DC-Stromversorgungsnetzes 42 führt die Verwendung des erfindungsgemäßen Hochleistungsschalters 30, 41 zu einer sehr großen Anzahl an Möglichkeiten zur Versorgung der Verbraucher durch die verschiedenen Generatoren 32, 33 und 34, sodass eine maximale Flexibilität hinsichtlich der Sicherstellung der Energieversorgung der Verbraucher gewährleistet ist. Die Hochleistungsschalter 30, 41 erlauben dabei, dass auch große Leistungen bei geringem apparativen Aufwand geschaltet werden können.

## Patentansprüche

1. Hochleistungsschalter (1) zur Unterbrechung eines DC-Stromkreises (2) mit zwei Strompfaden (2a, 2b) für eine Mindestleistung von 30kW, wobei mindestens zwei in einem der Strompfade (2a, 2b) antiseriell geschaltete Transistoren (3, 4) derart vorgesehen sind, dass jeder Transistor genau eine der beiden möglichen Stromrichtungen sperren oder durchschalten kann und mindestens eine Steuereinheit (5) zur Ansteuerung der Transistoren vorgesehen ist,
wobei zwischen den antiseriellen Transistoren (3, 4) des einen Strompfades (2a, 2b) ein zuschaltbarer ohmscher Widerstand (R) vorgesehen ist, über welchen der Stromkreis (2) kurzgeschlossen werden kann.

2. Schalter nach Anspruch 1,
wobei IGBT's (3a, 4a) mit Freilaufdioden (3b, 4b) zur Bereitstellung der antiseriellen Transistoren (3, 4) im Strompfad (2a) vorgesehen sind.

3. Schalter nach Anspruch 1 oder 2,
wobei mindestens ein Transistor (6) zum Zuschalten des ohmschen Widerstandes (R) vorgesehen ist.

4. Schalter nach einem der Ansprüche 1 bis 3,
wobei der mindestens eine zuschaltbare ohmsche Widerstand (R) über die Steuereinheit (5) oder über einen Choppertreiber (22') zuschaltbar ist.

5. Schalter nach einem der Ansprüche 1 bis 4,
wobei mindestens ein Strompfad (2a, 2b) mehrere parallele Unterstrompfade (2a', 2a") aufweist, in welchen jeweils zwei antiseriell geschaltete Transistoren (3, 4) derart vorgesehen sind, dass jeder Transistor jeweils eine der beiden möglichen Stromrichtungen des Unterstrompfads sperren oder durchschalten kann.

6. Schalter nach Anspruch 5,
wobei jeder der Unterstrompfade (2a', 2a") zwischen den antiseriellen Transistoren (3, 4) über mindestens einen zuschaltbaren ohmschen Widerstand (R) kurzgeschlossen werden kann.

7. Schalter nach Anspruch 5 oder 6,
wobei jeder Unterstrompfad (2a', 2a") über eine Diode (6, 7) mit dem mindestens einen zuschaltbaren ohmschen Widerstand (R) verbunden ist.

8. Schalter nach einem der Ansprüche 1 bis 7,
wobei eine parallel zum zuschaltbaren ohmschen Widerstand (R) und zum zugehörigen Transistor (6) geschaltete Kapazität (10) vorgesehen ist und optional eine Freilaufdiode (11) parallel zum ohmschen Widerstand (R) vorgesehen ist.

9. Schalter nach einem der Ansprüche 1 bis 8,
wobei am Eingang (12), am Ausgang (13) des Schalters und/oder zwischen den mindestens zwei antiseriell geschaltete Transistoren (3, 4) Mittel (14, 15, 16) zur Spannungs- und/oder Strommessung vorgesehen sind.

10. Schalter nach einem der Ansprüche 1 bis 9,
wobei am Eingang (12) oder am Ausgang (13) die Strompfade über ein Dämpfungsglied (17, 18) verbunden sind und optional eine zum Dämpfungsglied parallel geschaltete Diode (20) vorgesehen ist.

11. Schalter nach einem der Ansprüche 1 bis 10,
wobei mindestens ein Temperatursensor (19) vorgesehen ist.

12. Schalter nach einem der Ansprüche 1 bis 11,
wobei die Steuereinheit (5) einen der Strompfade (2a, 2b) oder alle parallelen Unterstrompfade (2a', 2a") trennen und die Strompfade oder Unterstrompfade über den mindestens einen zuschaltbaren ohmschen Widerstand (R) bei einem oder mehrerer der folgenden Zustände kurzschließen kann:
- Überschreiten eines vorbestimmten Gesamtstromwertes im Strompfad oder Teilstromwertes im Unterstrompfad,
- Überschreiten eines vorgegebenen Spannungswertes am Eingang, Ausgang oder am DC-Chopper,
- Überschreiten einer vorgegebenen Spannungsdifferenz zwischen Eingang und Ausgang,
- Überschreiten eines Temperaturwertes,
- Anliegen eines übergeordneten Schaltsignals.

13. Schalter nach einem der Ansprüche 1 bis 12,
wobei die Steuereinheit (5) einen der Strompfade (2a, 2b) oder alle parallelen Unterstrompfade (2a', 2a") bei einem oder mehrerer der folgenden Zustände durchschalten kann:
- Unterschreiten eines vorbestimmten Gesamtstromwertes im Strompfad oder Teilstromwertes im Unterstrompfad,
- Unterschreiten einer vorgegebenen Spannung am Eingang, Ausgang oder am DC-Chopper,
- Unterschreiten einer vorgegebenen Spannungsdifferenz zwischen Eingang und Ausgang
- Unterschreiten eines Temperaturwertes,
- Anliegen eines übergeordneten Schaltsignals.

14. Schalter nach einem der Ansprüche 1 bis 13,
wobei zum Ansteuern der IGBT's Treibereinheiten (22, 22') vorgesehen sind.

15. Verwendung eines Schalters (30, 41) nach Anspruch 1 bis 14 in verteilten DC-Stromnetzen (42), in Hochspannungsgleichstromnetzen oder in DC-Netzen für eine Mindestleistung von 30 kW von mit Wechselrichtern betriebenen elektrischen Antrieben, Generatoren oder Energiespeichern.

16. Verwendung nach Anspruch 15,
wobei der Schalter in Antrieben für Schiffe, Bohrinseln, Seilwinden, Pumpenantrieben, Kraftfahrzeugen verwendet wird.

## Claims

1. A high-power switch (1) for the interruption of a DC power circuit (2) with two current paths (2a, 2b) for a minimum power of 30 kW, wherein
at least two transistors (3, 4) connected in anti-series are provided in one of the current paths (2a, 2b), such that each transistor can block or interconnect exactly one of the two possible current directions, and at least one control unit (5) is provided for the actuation of the transistors, wherein
between the anti-series transistors (3, 4) of the one current path (2a, 2b) there is provided a switchable ohmic resistance (R), by means of which the electrical circuit (2) can be short-circuited.

2. The switch according to claim 1, wherein
IGBTs (3a, 4a) with freewheeling diodes (3b, 4b) are provided for the provision of the anti-series transistors (3, 4) in the current path (2a).

3. The switch according to claim 1 or 2, wherein
at least one transistor (6) is provided for purposes of switching in the ohmic resistance (R).

4. The switch according to one of the claims 1 to 3, wherein
the at least one switchable ohmic resistance (R), can be switched via the control unit (5) or via a chopper driver (22').

5. The switch according to one of the claims 1 to 4, wherein
at least one current path (2a, 2b) has a plurality of parallel current sub-paths (2a', 2a"), in which two transistors (3, 4) connected in anti-series are provided in each case, such that each transistor can block or interconnect one of the two possible current directions of the current sub-path.

6. The switch according to claim 5, wherein
each of the current sub-paths (2a', 2a") between the anti-series transistors (3, 4) can be short-circuited via at least one switchable ohmic resistance (R).

7. The switch according to claim 5 or 6, wherein
each current sub-path (2a', 2a") is connected via a diode (6, 7) with the at least one connectable ohmic resistance (R).

8. The switch according to one of the claims 1 to 7, wherein
a capacitance (10) is provided, connected in parallel with the switchable ohmic resistance (R) and the corresponding transistor (6), and a freewheeling diode (11) is optionally provided in parallel with the ohmic resistance (R).

9. The switch according to one of the claims 1 to 8, wherein
at the input (12), at the output (13) of the switch, and/or between the at least two transistors (3, 4), connected in anti-series, means (14, 15, 16) are provided for measuring voltage and/or current.

10. The switch according to one of the claims 1 to 9, wherein
at the input (12), or at the output (13), the current paths are connected via an attenuator (17, 18), and a diode (20) is optionally provided, connected in parallel with the attenuator.

11. The switch according to one of the claims 1 to 10, wherein at least one temperature sensor (19) is provided.

12. The switch according to one of the claims 1 to 11, wherein
the control unit (5) can disconnect one of the current paths (2a, 2b) or all of the parallel current sub-paths (2a', 2a"), and can short-circuit the current paths or current sub-paths via the at least one connectable ohmic resistance (R), in one or a plurality of the following states:
- An exceedance of a predetermined total current value in the current path or partial current value in the current sub-path,
- An exceedance of the prescribed voltage value at input, output, or on the DC chopper,
- An exceedance of a prescribed voltage difference between input and output,
- An exceedance of a temperature value,
- Application of an overriding switching signal.

13. The switch according to one of the claims 1 to 12, wherein
the control unit (5) can interconnect one of the current paths (2a, 2b) or all parallel current sub-paths (2a', 2a"), in one or a plurality of the following states:
- A fall below a predetermined total current value in the current path or partial current value in the current sub-path,
- A fall below a prescribed voltage value at input, output, or on the DC chopper,
- A fall below a prescribed voltage difference between input and output,
- A fall below a temperature value,
- Application of an overriding switching signal.

14. The switch according to one of the claims 1 to 13, wherein
driver units (22, 22') are provided for purposes of actuating the IGBTs.

15. Use of a switch (30, 41) according to claim 1 to 14 in distributed DC power networks (42), in high-voltage DC current networks, or in DC networks for a minimum power of 30 kW of electrical drives, generators, or energy stores operated with inverters.

16. The use according to claim 15, wherein
the switch is used in drives for ships, drilling rigs, cable winches, pump drives, motor vehicles.

## Revendications

1. Disjoncteur à haut puissance (1) pour interrompre un circuit de courant continu (2) avec deux trajets de courant (2a, 2b) pour une puissance minimale de 30 kW, au moins deux transistors (3, 4) connectés de manière antisérielle dans un des trajets de courant (2a, 2b) étant prévus de telle manière que chaque transistor peut bloquer ou mettre en connexion exactement une des deux directions de courant possibles et au moins une unité de commande (5) étant prévue pour commander les transistors, une résistance ohmique connectable (R) étant prévue entre les transistors antisériels (3, 4) du trajet de courant (2a, 2b) par le biais de laquelle le circuit de courant (2) peut être court-circuité.

2. Disjoncteur selon la revendication 1, des transistors bipolaires à grille isolée (IGBT) (3a, 4a) avec des diodes de marche à vide (3b, 4b) étant prévus pour la mise en oeuvre des transistors antisériels (3, 4) dans le trajet de courant (2a).

3. Disjoncteur selon la revendication 1 ou 2, au moins un transistor (6) étant prévu pour connecter la résistance ohmique (R).

4. Disjoncteur selon l'une quelconque des revendications 1 à 3, au moins une résistance ohmique connectable (R) pouvant être connecté par le biais de l'unité de commande (5) ou d'un circuit pilote hacheur (22').

5. Disjoncteur selon l'une quelconque des revendications 1 à 4, au moins un trajet de courant (2a, 2b) comportant plusieurs trajets de courant subordonnés (2a', 2a") parallèles dans lesquels respectivement deux transistors (3, 4) connectés de manière antisérielle sont prévus de telle manière que chaque transistor peut bloquer ou mettre en connexion respectivement une des deux directions de courant possibles du trajet de courant subordonné.

6. Disjoncteur selon la revendication 5, chacun des trajets de courant subordonnés (2a', 2a") pouvant être court-circuité entre les transistors antisériels (3, 4) par au moins une résistance (R) ohmique connectable.

7. Disjoncteur selon la revendication 5 ou 6, chaque trajet à minimum de courant (2a', 2a") étant relié par une diode (6, 7) à au moins une résistance (R) ohmique connectable.

8. Disjoncteur selon l'une quelconque des revendications 1 à 7, une capacité (10) connectée parallèlement à la résistance (R) ohmique connectable et au transitor correspondant (6) étant prévue et une diode de marche à vide (11) en option étant prévue parallèlement à la résistance (R) ohmique connectable.

9. Disjoncteur selon l'une quelconque des revendications 1 à 8, des moyens (14, 15, 16) étant prévus pour la mesure de tension et/ou de courant à l'entrée (12), à la sortie (13) du disjoncteur et/ou entre au moins deux transistors connectés de manière antisérielle (3, 4).

10. Disjoncteur selon l'une quelconque des revendications 1 à 9, les trajets de courant étant reliés par un élément d'amortissement (17, 18) à l'entrée (12) ou à la sortie (13) et une diode (20) connectée en parallèle à l'élément d'amortissement étant prévue en option.

11. Disjoncteur selon l'une quelconque des revendications 1 à 10, au moins un capteur de température (19) étant prévu.

12. Disjoncteur selon l'une quelconque des revendications 1 à 11, l'unité de commande (5) pouvant séparer un des trajets de courant (2a, 2b) ou tous les trajets de courant subordonnés (2a', 2a") parallèles et pouvant court-circuiter les trajets de courant ou les trajets de courant subordonnés par au moins une résistance (R) ohmique connectable pour un ou plusieurs états suivants :
- dépassement d'une valeur de courant total prédéfinie dans le trajet de courant ou d'une valeur de courant partiel dans le trajet à minimum de courant,
- dépassement d'une valeur de tension prédéfinie à l'entrée, à la sortie ou sur le circuit pilote hacheur de courant continu,
- dépassement d'une différence de tension prédéfinie entre l'entrée et la sortie,
- dépassement d'une valeur de température,
- application d'un signal de connexion prioritaire.

13. Disjoncteur selon l'une quelconque des revendications 1 à 12, l'unité de commande (5) pouvant mettre en connexion un des trajets de courant (2a, 2b) ou tous les trajets de courant subordonnés (2a', 2a") parallèles pour un ou plusieurs états suivants :
- dépassement d'une valeur de courant total prédéfinie dans le trajet de courant ou d'une valeur de courant partiel dans le trajet à minimum de courant,
- dépassement d'une tension prédéfinie à l'entrée, la sortie ou sur le circuit pilote hacheur de courant continu,
- dépassement d'une différence de tension prédéfinie entre l'entrée et la sortie,
- dépassement d'une valeur de température,
- application d'un signal de connexion prioritaire.

14. Disjoncteur selon l'une quelconque des revendications 1 à 13, des unités pilotes (22, 22') étant prévues pour commander les transistors bipolaires à grille isolée (IGBT).

15. Utilisation d'un disjoncteur (30, 41) selon la revendication 1 à 14 dans des réseaux répartis de courant continu (42), dans des réseaux de courant continu à haute tension ou dans des réseaux à courant continu pour une puissance minimale de 30 kW de systèmes d'entraînement, de générateurs ou d'accumulateurs d'énergie électriques fonctionnant avec des onduleurs.

16. Utilisation selon la revendication 15, le disjoncteur étant utilisé dans des systèmes de propulsion de navires, de plateformes de forage, de treuils de câble, de système d'entraînement de pompes, de véhicules automobiles.
